# EUROPEAN PATENT APPLICATION

(11) **EP 4 383 353 A1**
(43) Date of publication of application: **12.06.2024**
(21) Application number: 23211807.5
(22) Date of filing: 23.11.2023
(51) Int. Cl.: H01L 31/0465, H01L 31/05, H01L 31/068, H01L 31/0224

(54) **BACK-CONTACT SOLAR CELL, BACK-CONTACT SOLAR CELL SEGMENT, PHOTOVOLTAIC MODULE AND STRING WELDING METHOD**

(30) Priority: 05.12.2022 CN 202211552101
(71) Applicant: Trina Solar Co., Ltd, Changzhou, Jiangsu 213031 (CN)
(72) Inventor: ZHANG, Shu, CHANGZHOU 213031 (CN); CHU, Haiyuan, CHANGZHOU 213031 (CN); DING, Yi, CHANGZHOU 213031 (CN); LIU, Wei, CHANGZHOU 213031 (CN)
(74) Representative: Nederlandsch Octrooibureau

(57) **Abstract**

A back-contact solar cell, a back-contact solar cell segment, a string welding method of solar cell, and a back-contact solar cell are provided. The back-contact solar cell, comprises: a substrate including three substrate segments, wherein the three substrate segments are adjacently arranged in a first direction; and an even number of positive main grids and negative main grids located on a backlight surface of each substrate segment, wherein the positive main grids and negative main grids extend in the first direction and are alternately arranged in a second direction, an extension line of each positive main grid located on each substrate segment coincides with an extension line of one of the negative main grids located on an adjacent substrate segment, and an extension line of each negative main grid located on each substrate segment coincides with an extension line of one of the positive main grids located on the adjacent substrate segment.

## Description

### Technical field

This disclosure mainly relates to the field of photovoltaic technology, specifically to a back-contact solar cell, a back-contact solar cell segment, a photovoltaic module, and a string welding method.

### Background

Back-contact Solar Cell, referred to as "IBC", is a solar cell with both positive electrodes and negative electrodes on the backlight surface of the cell. The back-contact solar cell can reduce the blocking of the light-receiving surface of the cell by the electrodes and improve the energy conversion efficiency of the cell.

In current back-contact solar cell, the backlight surface of entire solar cell contains a plurality of parallel and spaced positive main grids and negative main grids. In the process of string welding a plurality of solar cells into photovoltaic module, it is required to cut the entire solar cell into a plurality of solar cell segments, and adjust the positions of the solar cell segments and the entire solar cell. Consequently, in adjacent solar cell segments, the extension lines of the positive main grids of one solar cell segment is in line with the extension lines of the negative main grids of another solar cell segment, and welding strips can be used to connect the positive main grids and negative main grids in the adjacent solar cell segments. In the process of connecting solar cells into photovoltaic modules, the positions of the solar cells and solar cell segments need to be adjusted, which increases the production steps of photovoltaic modules and leads to a reduction in production efficiency.

In addition, back-contact solar cells in traditional technology mainly are entire solar cell or two-segment solar cell. In the process of string welding cells with welding strips, the cells and welding strips will experience thermal expansion and cooling contraction. During the cooling process after welding, the shrinkage of the welding strips and the cells is different as the thermal expansion coefficient of the welding strips is much higher than that of the cells, which causes the cells to warp toward the welding strip. The warping of the cells will increase the difficulty in controlling the string length of the cells, cause fragmentation and cracks in the cells during the circulation process, and increase the risk of fragmentation and cracks during the lamination process.

Therefore, how to reduce the production steps of photovoltaic modules, improve production efficiency, and reduce the warpage of cells during the string welding process is an issue that needs to be solved urgently.

### Summary

The technical problem to be solved by this disclosure is to provide a back-contact solar cell, a back-contact solar cell segment, and a string welding method all of which can reduce the steps of preparing photovoltaic modules and improve production efficiency, and a photovoltaic module which requires fewer manufacturing steps, the photovoltaic module also has high production efficiency and reduces the warpage of the cells during the string welding process.

In order to achieve this purpose, the present disclosure proposes the following technical solutions: a back-contact solar cell, comprising: a substrate including three substrate segments, wherein the three substrate segments are adjacently arranged in a first direction; and an even number of positive main grids and negative main grids located on a backlight surface of each substrate segment, wherein the positive main grids and negative main grids extend in the first direction and are alternately arranged in a second direction, an extension line of each positive main grid located on each substrate segment coincides with an extension line of one of the negative main grids located on an adjacent substrate segment, and an extension line of each negative main grid located on each substrate segment coincides with an extension line of one of the positive main grids located on the adjacent substrate segment.

In one embodiment, the back-contact solar cell further comprises a plurality of rows of positive connection points and a plurality of rows of negative connection points, wherein the positive connection points of each row are arranged at intervals in the first direction on a corresponding positive main grid, and the negative connection points of each row are arranged at intervals in the first direction on a corresponding negative main grid.

In one embodiment, a total number of the positive main grids and the negative main grids is 4, 6, 8, 10, 12, 14, 16, 18, 20, 22, or 24, and a number of the negative main grids is same as a number of the positive main grids.

The present disclosure proposes a back-contact solar cell segment, comprising: three solar cell segments obtained by dividing the solar cell along a dividing line between adjacent substrate segments, wherein the three solar cell segments correspond to the three substrate segments.

The present disclosure proposes a photovoltaic module, comprising: a plurality of solar cell segments, wherein the plurality of solar cell segments are arranged at intervals in a third direction, and an extension line of each positive main grid located on each solar cell segment coincides with an extension line of one of the negative main grids located on adjacent solar cell segments, and an extension line of each negative main grid located on each solar cell segment coincides with an extension line of one of the positive main grids located on adjacent solar cell segments; and a plurality of welding strips extending in the third direction, wherein each welding strip connects one of the positive main grids with a corresponding negative main grid.

The present disclosure proposes a string welding method of solar cell, comprising: obtaining at least two solar cells; dividing each solar cell into a first solar cell segment, a second solar cell segment, and a third solar cell segment along a dividing line between adjacent substrate segments of each solar cell, wherein the first solar cell segment, the second solar cell segment, and the third solar cell segment respectively correspond to a first substrate segment, a second substrate segment, and a third substrate segment; arranging the at least two solar cells adjacently in a third direction, wherein one of the adjacent solar cells is rotated 180° so that one first solar cell segment in the adjacent solar cells is adjacent to another first solar cell segment in the adjacent solar cells, or one third solar cell segment in the adjacent solar cells is adjacent to another third solar cell segment in the adjacent solar cells; and string welding each solar cell segment of the at least two solar cells.

The present disclosure proposes a back-contact solar cell, comprising: a substrate including three substrate segments, wherein three substrate segments are adjacently arranged in a first direction; and an even number of positive main grids and negative main grids located on the backlight surface of each substrate segment, wherein the positive main grids and the negative main grids extend in the first direction and are alternately arranged in a second direction, an extension line of each positive main grid located on each substrate segments coincides with an extension line of one of the positive main grids located on an adjacent substrate segment, an extension line of each negative main grid on the substrate segment coincides with an extension line of one of the negative main grids located on the adjacent substrate segment.

In one embodiment, the back-contact solar cell further comprises a plurality of rows of positive connection points and a plurality of rows of negative connection points, wherein the positive connection points of each row are arranged at intervals in the first direction on corresponding positive main grid, the negative connection points of each row are arranged at intervals in the first direction on a corresponding negative main grid.

In one embodiment, a total number of the positive main grids and the negative main grids is 4, 6, 8, 10, 12, 14, 1 6, 18, 20, 22, or 24, and a number of negative main grids is same as a number of positive main grids.

The present disclosure proposes a back-contact solar cell segment, comprising: three solar cell segments obtained by dividing the solar cell along a dividing line between adjacent substrate segments, wherein the three solar cell segments correspond to the three substrate segments.

The present disclosure proposes a photovoltaic module, comprising: a plurality of solar cell segments, wherein the plurality of solar cell segments is arranged at intervals in a fourth direction, and an extension line of each positive main grid located on each solar cell segment coincides with an extension line of one of the negative main grids located on adjacent solar cell segments, and an extension line of each negative main grid located on each solar cell segment coincides with an extension line of one of the positive main grids located on adjacent solar cell segments; and a plurality of welding strips extending in the fourth direction, wherein each welding strip connects the positive main grid with corresponding negative main grid.

The present disclosure proposes a string welding method of solar cell, comprising: obtaining an at least two solar cells; dividing each solar cell into a first solar cell segment, a second solar cell segment, and a third solar cell segment along a dividing line between adjacent substrate segments of each solar cell, wherein the first solar cell segment, the second solar cell segment, and the third solar cell segment respectively correspond to a first substrate segment, a second substrate segment, and a third substrate segment; arranging the at least two solar cells adjacently in a fourth direction, wherein the second solar cell segment in each solar cell is rotated 180°, and one solar cell in the adjacent solar cells is rotated 180° so that one first solar cell segment in the adjacent solar cells is adjacent to another first solar cell segment in the adjacent solar cells, or one third solar cell segment in the adjacent solar cells is adjacent to another third solar cell segment in the adjacent solar cells; and string welding each solar cell segment of the at least two solar cells.

The positive main grids and the negative main grids on the solar cell of the present disclosure extend in the first direction and are alternately arranged in the second direction, and the positive main grids and negative main grids on the adjacent substrate segments have a corresponding relationship. Thus, when string welding the entire cell, only one of the adjacent entire cells need to be rotated without alignment operation, thereby saving process steps and reducing the warpage of cells during the string welding process.

### Description of the drawings

In order to make the above purposes, features and advantages of the present disclosure more obvious and understandable, the specific embodiments of the present disclosure are described in detail below with reference to the accompanying drawings, wherein:
FIG 1 is a schematic plan view of a back contact solar cell according to an embodiment of the present disclosure;
FIG 2 is a schematic plan view of an entire solar cell according to an embodiment of the present disclosure;
FIG 3 is a schematic plan view of a photovoltaic module according to another embodiment of the present disclosure;
FIG 4 is a schematic plan view of a back-contact solar cell according to an embodiment of the present disclosure;
FIG 5 is a schematic plan view of a solar cell segment with an odd number of positive main grids and negative main grids;
FIG 6 is a schematic diagram of the warpage of a two-segment solar cell and a three-segment solar cell during the string welding process;
FIG 7 shows the power loss when substrates with the same size are divided into different numbers of solar cell segments in an embodiment of the present disclosure.

### Reference signs

| | | | |
|---|---|---|---|
| solar cells | 100 | positive connection point | 150 |
| substrate | 110, 230 | negative connection point | 160 |
| first substrate segment | 111, 231 | entire cell | 210, 220, 10, 20 |
| second substrate segment | 112, 232 | first solar cell segment | 211, 221 |
| third substrate segment | 113, 233 | second solar cell segment | 212, 222 |
| positive main grid | 120, 240, 31 | third solar cell segment | 213, 223 |
| negative main grid | 130, 250, 32 | welding strip | 190, 510, 610 |
| first centerline | 141 | solar cell segment | 520, 620, 11, 12, 13, 21, 22, 23 |
| Second centerline | 142 | | |

### Detailed ways

In order to make the above objects, features and advantages of the present disclosure more obvious and understandable, the specific embodiments of the present disclosure are described in detail below with reference to the accompanying drawings.

Many specific details are set forth in the following description to fully understand the present disclosure, but the present disclosure can also be implemented in other ways different from those described here, so the present disclosure is not limited by the specific embodiments disclosed below.

As shown in this disclosure and claims, words such as "a", "an", "an" and/or "the" do not specifically refer to the singular and may include the plural unless the context clearly indicates an exception. Generally speaking, the terms "comprising" and "comprising" only imply the inclusion of clearly identified steps and elements, and these steps and elements do not constitute an exclusive list. The method or apparatus may also include other steps or elements.

In addition, it should be noted that the use of words such as "first" and "second" to define parts is only to facilitate the distinction between corresponding parts. Unless otherwise stated, the above words have no special meaning and therefore cannot be understood. To limit the scope of protection of this disclosure. In addition, although the terms used in this disclosure are selected from well-known and commonly used terms, some terms mentioned in the specification of this disclosure may be selected by the applicant based on his or her judgment, and their detailed meanings are set out herein, their detailed meanings stated in the relevant section of the description. Furthermore, the disclosure is required to be understood not merely by the actual terms used, but also by the meaning connoted by each term.

Flowcharts are used in this disclosure to illustrate operations performed by systems according to embodiments of this disclosure. It should be understood that the preceding or following operations are not necessarily performed in exact order. Instead, the various steps can be processed in reverse order or simultaneously. And, other operations may be added to these processes, or a step or steps may be removed from these processes.

The back-contact solar cell, the back-contact solar cell segment, the photovoltaic module, and the string welding method of the present disclosure will be described through specific embodiments.

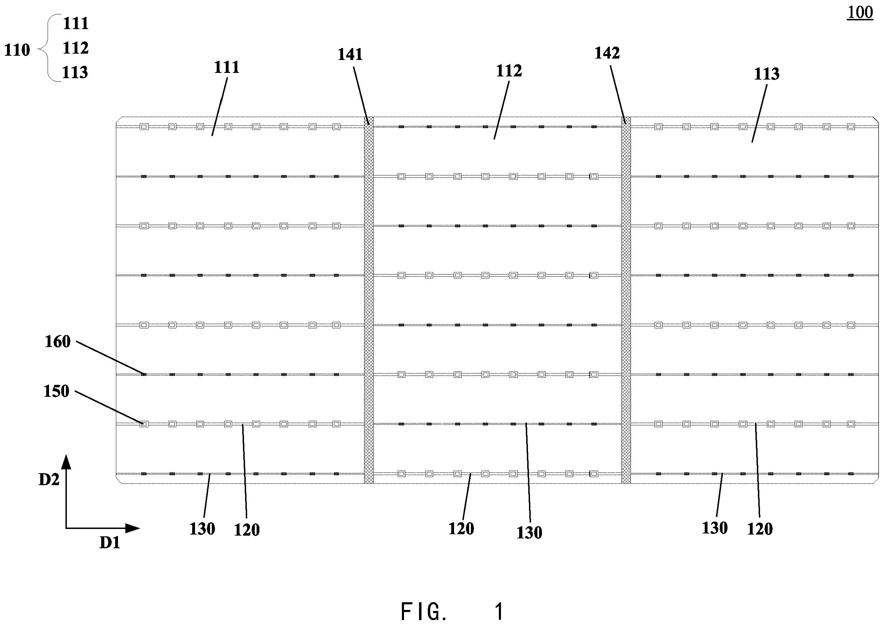

FIG. 1 is a schematic plan view of a back-contact solar cell according to an embodiment of the present disclosure. Referring to FIG 1, the back contact solar cell 100 (hereinafter referred to as solar cell) includes a substrate 110, a plurality of positive main grids 120, and a plurality of negative main grids 130. The substrate 110 has three substrate segments, and an even number of positive main grids 120 and negative main grids 130 are disposed on the backlight surface of each substrate segment.

Specifically, as shown in FIG. 1, the substrate 110 includes three substrate segments, a first substrate segment 111, a second substrate segment 112, and a third substrate segment 113. The first substrate segment 111, the second substrate segment 112 and the third substrate segment 113 are arranged adjacently in the first direction D1, and the areas of the three substrate segments are equal. The first substrate segment 111 and the second substrate segment 112 are symmetrical about the first centerline 141 in the first direction D1, and the second substrate segment 112 and the third substrate segment 113 are symmetrical about the second centerline 142 in the first direction D1. An even number of the positive main grids 120 and the negative main grids 130 are arranged alternately in the second direction D2 on the backlight surface of the first substrate segment 111. The positive main grids 120 and the negative main grids 130 extend in the first direction D1. The total number of the positive main grids 120 and the negative main grids 130 is not limited to 8 as shown in FIG 1, and can be any other even number equal to or greater than 2. For example, in some embodiments, the total number of positive main grids 120 and negative main grids 130 is 4, 6, 8, 10, 12, 14, 16, 18, 20, 22, or 24, and the number of positive main grids 120 is same as the number of negative main grids 130.

Like the positive main grids 120 and the negative main grids 130 on the first substrate segment 111, an even number of positive main grids 120 and the negative main grids 130 are arranged alternately in the second direction D2 on the backlight surfaces of the second substrate segment 112 and the third substrate segment 113, and the positive main grids 120 and negative main grids 130 extend in the first direction D1.As shown in FIG. 1, the extension line of each positive main grid 120 on the second substrate segment 112 coincides with the extension line of one negative main grid 130 on the first substrate segment 111 and the extension line of one negative main grid 130 on the second substrate segment 113, and the extension line of each negative main grid 130 on the second substrate segment 112 coincides with the extension line of one positive main grid 120 on the first substrate segment 111 and the extension line of one positive main grid 120 on the second substrate segment 113. In this way, in the subsequent string welding process, only one of two adjacent solar cells need to be rotated to complete the adjustment of the position of the solar cells, which is beneficial for improving the production efficiency of photovoltaic modules as will be discussed later. Referring to FIG. 1, in one embodiment, the solar cell 100 further includes a plurality of rows of positive connection points 150 and a plurality of rows of negative connection points 160. The positive connection points 150 of each row are arranged at intervals in the first direction D1 on a corresponding positive main grid 120, and the negative connection points 160 of each row are arranged at intervals in the first direction D1 on a corresponding negative main grid 130. This disclosure does not limit the distance between the positive connection points and the distance between the negative connection points, both of which can be set according to needs. The positive connection point and the negative connection point can be used as the solder joints for the welding strip, so that the positive main grid can be connected to the welding strip through the positive connecting point, and the negative main grid can be connected to the welding strip through the negative connecting point.

In this disclosure, the above-mentioned solar cells can be cut along its centerline to obtain solar cell segments.

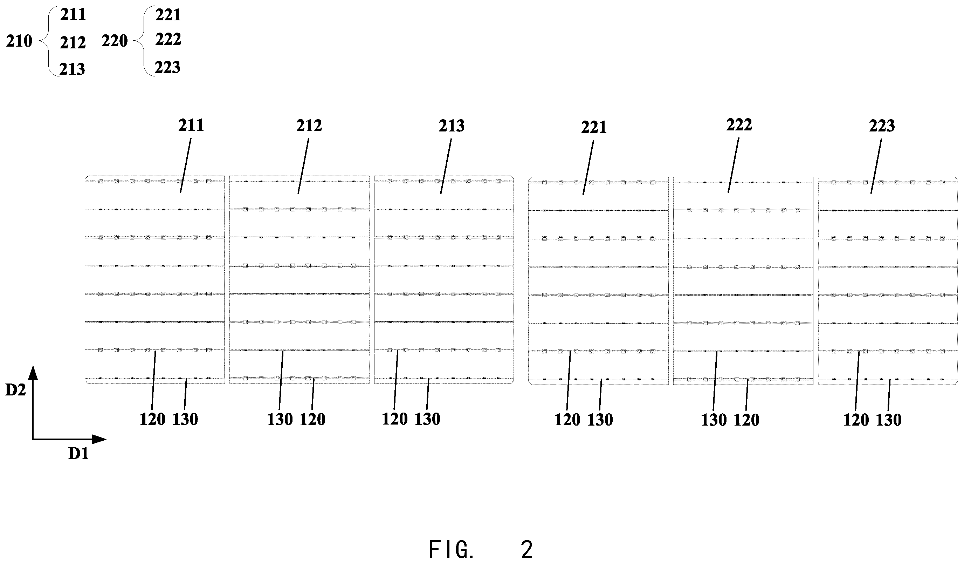

FIG. 2 is a schematic plan view of an entire solar cell according to an embodiment of the present disclosure. Referring to FIGs. 1 and 2, the substrate 110 is non-destructively cut along the first centerline 141 and the second centerline 142 in FIG. 1 to obtain three solar cell segments, a first solar cell segment 211, a second solar cell segment 212, a the third solar cell segment 223, which are from the same substrate 110. Among them, the first solar cell segment 211 corresponds to the first substrate segment 111, the second solar cell segment 212 corresponds to the second substrate segment 112, and the third solar cell segment 213 corresponds to the third substrate segment 113. To distinguish from the substrate 110 in FIG 1, the first solar cell segment 211, the second solar cell segment 212, and the third solar cell segment 223 are collectively referred to as the entire solar cell 220, that is, the entire solar cell 220 includes three solar cell segments, the first solar cell segment 211, the second solar cell segment 212, and the third solar cell segment 223.

As shown in FIG. 2, the first solar cell segment 211, the second solar cell segment 212, and the third solar cell segment 213 in the entire solar cell 210 are arranged at intervals in the first direction D1. The extension line of the positive main grid 120 on the second solar cell segment 212 coincides with the extension line of the negative main grid 130 on the first solar cell segment 211 and the extension line of the negative main grid 130 on the third solar cell segment 213, and the extension line of the negative main grid 130 on the second solar cell segment 212 coincides with the extension line of the positive main grid 120 on the first solar cell segment 211 and the extension line of the positive main grid 120 on the third solar cell segment 213. In this way, there is no need to perform 180° rotation process and alignment process on the solar cell segments after the cutting process, instead the positions of the first solar cell segment 211, the second solar cell segment 212, and the third solar cell segment 213 are kept after the cutting process, and solder strips are placed directly on the three solar cell segments.

Continuing to refer to FIG. 2, FIG. 2 illustrates two entire solar cells 210 and 220, and the entire solar cell 210 is adjacent to the entire solar cell 220 in the first direction D1. Among them, the first solar cell segment 221 in the entire solar cell 220 is adjacent to the third solar cell segment 213 in the entire solar cell 210. During the string welding process, the entire solar cell 210 or 220 needs to be rotated, which will be described next.

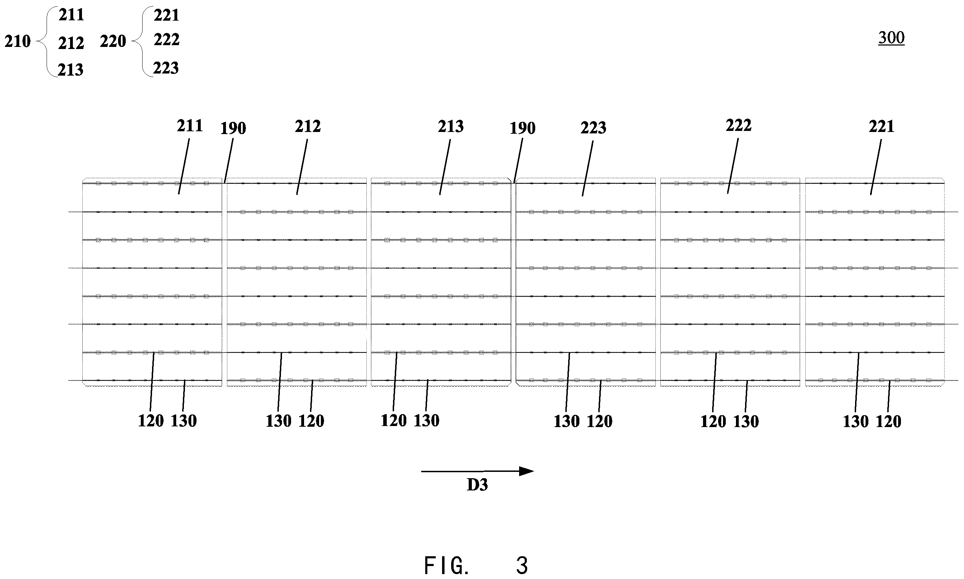

FIG 3 is a schematic plan view of a photovoltaic module according to an embodiment of the present disclosure. Referring to FIG. 3, the entire solar cell 210 and the entire solar cell 220 are arranged adjacently in the third direction D3. Among them, different from the arrangement direction of the three solar cell segments in the entire solar cell 210, the first solar cell segment 221, the second solar cell segment 222, and the third solar cell segment 223 in the entire solar cell 220 are sequentially arranged from right to left in the third direction D3. The entire solar cell 220 is rotated 180 ° while arranging the entire solar cell 210 and the entire solar cell 220. In this way, the third solar cell segment 213 in the entire solar cell 210 is adjacent to the third solar cell segment 223 in the entire solar cell 220. Since the total number of the positive main grids and the negative main grids on the solar cell segment in this disclosure is an even number, and the number of the positive main grids is the same as the number of the negative main grids after the entire solar cell 220 is rotated 180 °, the positive main grids and the negative main grids on the third solar cell segment 213 and 223 has the following corresponding relationship, the extension lines of the positive main grids 120 on the third solar cell segment 213 coincides with the extension lines of the negative main grids 130 on the third solar cell segment 223, the extension line of the negative main grids 130 on the third solar cell segment 213 coincides with the extension line of the positive main grids 120 on the third solar cell segment 223.

In addition, in some embodiments, the entire solar cell 220 in FIG. 3 can also be kept in its original orientation, that is, as shown in FIG 2, the first solar cell segment 221 is located on the far left, and the third cell 223 is on the far right. On this basis, the entire solar cell 210 is rotated 180°. In this way, the first solar cell segment 211 in the entire solar cell 210 is adjacent to the first solar cell segment 221 in the entire solar cell 220. Such that, the corresponding relationship between the positive main grid 120 and the negative main grid 130 in the third solar cell segments 212 and 223 is the same as FIG. 3. After the entire solar cell 210 is rotated 180°, the positive main grids and negative main grids of the adjacent first solar cell segments 211 and 221 also have the following corresponding relationship, the extension lines of the positive main grids 120 on the first cell segment 211 coincide with the extension lines of the negative main grids 130 on the second solar cell segment 221, and the extension lines of the negative main grids 130 on the first solar cell segment 211 coincides with the extension lines of the positive main grids 120 on the second solar cell segment 221.

It can be understood that the number of the entire solar cells in the photovoltaic module 300 is not limited to the two shown in FIG. 3, and can be set according to actual needs.

In the above embodiment, after one of the two adjacent solar cell segments is rotated, the positive main grids and the negative main grids in the two adjacent solar cell segments can have the corresponding relationship as described above. Based on this relationship, the welding strip 190 can be directly placed on the two adjacent solar cell segments without additional rotation process and alignment process.

On the other hand, the present disclosure also provides a string welding method of solar cell, which is suitable for stringing the solar cells in the embodiments. Next, the string welding method will be described through embodiments.

The string welding method includes the following steps,
Step S110: obtaining at least two solar cells as described above,
Step S120: dividing each solar cell into a first solar cell segment, a second solar cell segment, and a third solar cell segment along a dividing line between adjacent substrate segments of each solar cell,
Step S130: arranging the at least two solar cells adjacently in the third direction, wherein one of the adjacent solar cells is rotated 180° so that one first solar cell segment in the adjacent solar cells is adjacent to another first solar cell segment in the adjacent solar cells, or one third solar cell segment in the adjacent solar cells segments is adjacent to another third solar cell segment in the adjacent solar cells; and
Step S140: string welding each solar cell segment of the at least two solar cells.
Steps S110 to S140 are introduced with reference to FIG. 1, FIG. 2, and FIG. 3.

In step S110, two solar cells 100 with three substrate segments as shown in FIG. 1 are obtained.

Referring to FIG. 2, the substrate 110 is divided along the first centerline 141 (i.e., the dividing line) and the second centerline 142 (i.e., the dividing line) of the two solar cells 100 in FIG 1, to obtain the two entire solar cells 210 and 220 as shown in FIG 2. The entire solar cell 210 has three solar cell segments, a first solar cell segment 211, a second solar cell segment 212, and a third solar cell segment 213. The entire solar cell 220 also has three solar cell segments, a first solar cell segment 221, a second solar cell segment 222, and a third solar cell segment 223. Among them, the first solar cell segments 211 and 221, the second solar cell segments 212 and 222, and the third solar cell segments 213 and 223 respectively correspond to the first substrate segment 111, the second substrate segment 112, and the third substrate segment 113 in the respective substrates.

Referring to FIG. 3, in step S130, the two entire solar cells 210 and 220 in step S120 are arranged adjacently in the third direction D3, and the entire solar cell 220 in FIG. 2 is rotated 180° so that the third solar cell segment 223 of the entire solar cell 220 is adjacent to the third solar cell segment 213 of the entire solar cell 210, as shown in FIG 3, or the entire solar cell 210 is rotated 180°, so that the first solar cell segment 211 of the entire solar cell 210 is adjacent to the first solar cell segment 221 of the entire solar cell 220. In this way, the positive main grids and the negative main grids on adjacent solar cell segments have the corresponding relationship as described above.

In step S140, string welding each solar cell segment of the two entire solar cells 210 and 220 arranged in the third direction D3 in step S130. In this way, the photovoltaic module 300 shown in FIG 3 is obtained.

For other details about the string welding method of the present disclosure, please refer to the relevant descriptions above, and will not be repeated. The string welding method of this disclosure uses the three-segment mentioned above. It only needs to rotate one of the two adjacent entire solar cells and does not require an alignment process. It has the advantage of reducing process steps and improving the production efficiency of photovoltaic modules.

In addition to the solar cells in the previous embodiments, this disclosure also proposes another solar cell. Next, another solar cell will be described through embodiments.

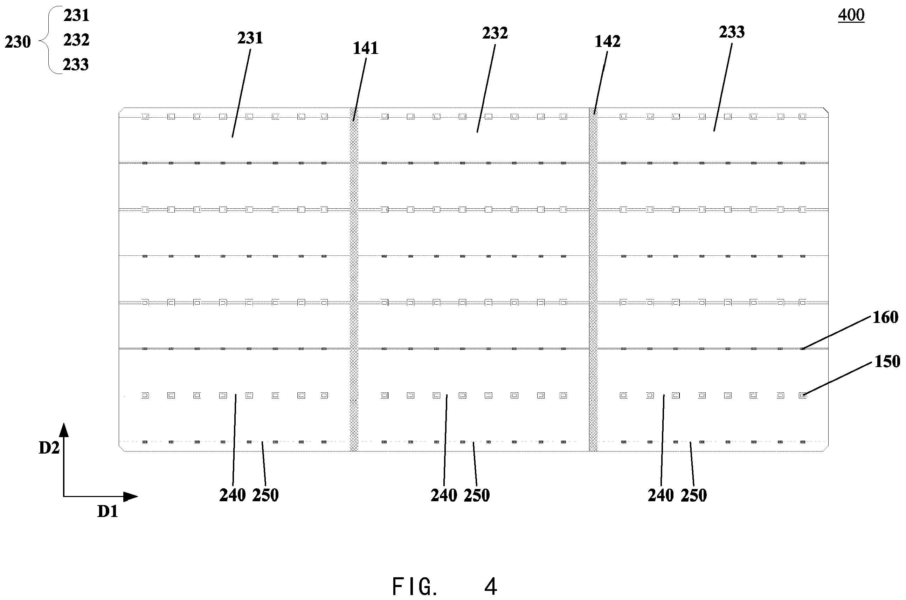

Refer to FIG. 4, which is a schematic plan view of a solar cell 400 according to an embodiment. It is the same with the solar cell 100 in FIG. 1 that the solar cell 400 also has a substrate 230 and an even number of positive main grids 240 and negative main grids 250. Among them, the substrate 230 also has three substrate segments arranged adjacently in the first direction D1, the first substrate segment 231, the second substrate segment 232, and the third substrate segment 233, and the first substrate segment 231 and the second substrate segment 232 is axially symmetrical about the first centerline 141, the second substrate segment 232 and the third substrate segment 233 are axially symmetrical about the second centerline 142, the positive main grid 240 and the negative main grid 250 are in the first direction. D1 extends and is alternately arranged in the second direction D2. What is different from the solar cell 100 in FIG. 1 is that, the extension line of each positive main grid 240 on the second substrate segment 232 coincides with the extension line of one positive main grid 240 on the first substrate segment 231 and the extension line of one positive main grid 240 on the third substrate segment 233, the extension line of each negative main grid 250 on the second substrate segment 232 coincides with the extension line of one negative main grid 250 on the first substrate segment 231and the extension line of one negative main grid 250 on the third substrate segment 233.

It can be understood that the total number of positive main grids and negative main grids on the solar cell in this disclosure is not limited to 8 in FIG 4, and it can be any even number that is equal to or greater than 2. For example, in some embodiments, the total number of positive main grids and negative main grids is 4, 6, 8, 10, 12, 14, 16, 18, 20, 22, or 24, wherein the number of negative main grids is the same as the number of positive main grids.

Referring to FIG. 4, the solar cell 400 further includes a plurality of rows of positive connection points 150 and a plurality of rows of negative connection points 160. The plurality of positive connection points 150 in each row are arranged at intervals on the corresponding positive main grid 240 in the first direction D1, and the plurality of negative connection points 160 in each row are arranged at intervals in the first direction D1 on the corresponding negative main grid 250.

In the embodiment of FIG. 4, the total number of positive main grids and negative main grids on the substrate segment is an even number. In this way, only the solar cell segment in the middle in the first direction D1 needs to be rotated 180 ° while string welding the solar cell segments from the same substrate subsequently, eliminating the need for alignment operations and saving process steps. This will be explained later.

The disclosure also proposes a back-contact solar cell segment. The solar cell segment comes from the substrate segment in FIG. 4. Referring to FIG. 4, the substrate 230 is segmented along the first centerline 141 and the second centerline 142 to obtain three solar cell segments. The three solar cell segments respectively from the first substrate segment 231, the second substrate segment 232 and the third substrate segment 233. For the description of this part, please refer to the previous relevant descriptions, and will not be repeated here. Since the total number of positive main grids and negative main grids on the three solar cell segments is an even number, in the subsequent string welding of three solar cell segments from the same substrate, only the solar cell segment in the middle in the first direction D1 needs to be rotated 180°, thereby eliminating the need for alignment and saving process steps.

This disclosure also proposes a photovoltaic module, which includes a plurality of solar cell segments and a plurality of welding strips. Wherein, the above-mentioned plurality of solar cell segments come from the substrate as shown in FIG 4. In other words, the plurality of solar cell segments come from the substrate in which the extension lines of each positive main grid coincide with each other, and the extension lines of each negative main grid coincide with each other.

Referring to FIG. 4, the substrate 230 is divided into three solar cell segments corresponding to the first substrate segment 231, the second substrate segment 232, and the third substrate segment 233. The three solar cell segments constitute an entire solar cell. For the three solar cell segments in the entire solar cell, since the total number of the positive main grids and the negative main grids on the three solar cell segments is an even number when the solar cell segment located in the middle in the first direction D1 is rotated 180°, the extension line of each positive main grid on each solar cell segment from the same entire solar cell coincides with the extension line of one negative main grid located on the adjacent solar cell segment, and the extension line of each negative main grid on each solar cell segment coincides with the extension line of one positive main grid located on the adjacent solar cell segment. In this way, when string welding the three solar cell segments from the same entire solar cell, only the solar cell segment located in the middle of the three solar cell segments in the first direction D1 needs to be rotated 180°, without the need for an alignment process, which saves the process step. Subsequently, a plurality of the entire solar cells adjusted as above are arranged at intervals along the fourth direction, and the solar cell segments are welded together through a plurality of welding strips extending along the fourth direction.

In order to more clearly understand the technical effects of the even number of the positive main grids and the negative main grids in this disclosure, here the solar cell segment having the positive main grid and the negative main girds with a total number of even numbers in the present application are illustrated in combination with the positive main girds and the negative main grids with a total number of odd numbers in the traditional technology.

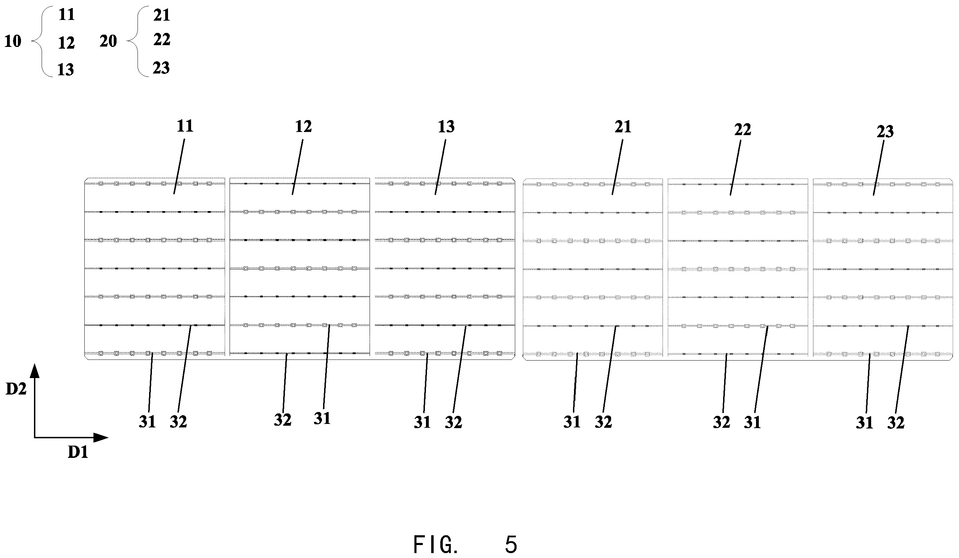

Referring to FIG. 5, which is a schematic plan view of a solar cell segment having the positive main grids and the negative main grids with a total number of even numbers. In FIG. 5, there are two entire solar cells 10 and 20 arranged adjacently in the first direction D1. The entire solar cell 10 has three solar cell segments 11, 12, and 13, and the entire solar cell 20 also has three solar cell segments 21, 22, and 23. Each solar cell segment has an odd number of positive main grids 31 and negative main grids 32, and the positive main grids 31 and negative main grids 32 on each solar cell segment are alternately arranged in the second direction D2. When string welding the entire solar cells 10 and 20, the solar cell segment 13 in the entire solar cell 10 is adjacent to the solar cell segment 21 in the entire solar cell 20. The extension line of each positive main grid 31 of the solar cell segment 13 coincides with a positive main grid 31 of the solar cell segment 21, and the extension line of each negative main grid 32 of the solar cell segment 13 coincides with a negative main grid 32 of the solar cell segment 21. As a result, the entire solar cell 10 and the entire solar cell 20 cannot be effectively connected through the welding strips. To solve this problem, it is necessary to change the arrangement of the positive main grid 31 and the negative main grid 32 of the entire solar cells 10 and 20, which increases the difficulty of controlling in industrialization process and reduces mass production efficiency.

Compared to solar cell segments with an odd number of the positive main grids and the negative main grids, in the present disclosure, when the solar cell segments with an even number of the positive main grid and the negative main grids are string-welded into a photovoltaic module, only one of the two adjacent entire solar cells needs to be rotated 180°, and there is no need for alignment process, which has the advantage of reducing process steps.

In the above embodiments, the substrate in the solar cell of the present disclosure has three substrate segments, and in subsequent process steps, the substrate is divided into three solar cell segments corresponding to the three substrate segments. Compared with the conventional technology of dividing the substrate into two solar cell segments, the above embodiment can significantly reduce the warpage of the solar cell segments during the string welding process by dividing the substrate into three solar cell segments, which does not increase the complication of the production process and the risk of module breakage, and which also can ensure high module production efficiency.

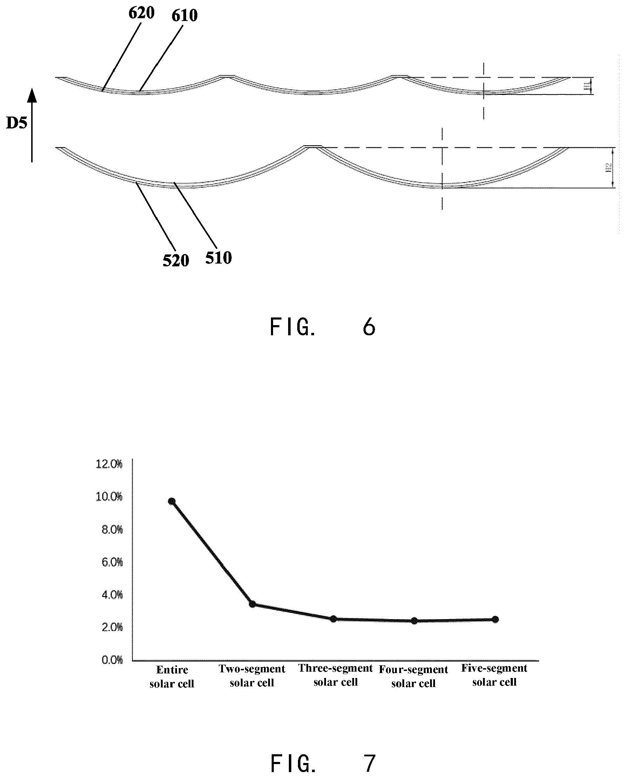

Specifically, referring to the schematic diagram of warpage of two-segment solar cell and three- segment solar cell during the string welding process shown in FIG 6. "Two-segment solar cell" refers to dividing the substrate into two solar cell segments, and "three-segment solar cell" refers to dividing the substrate into three solar cell segments, the dimension of the substrates divided into the two-segment segment and the three-segment segment of the substrate are the same. The length of one solar cell segment in two-segment solar cell is 50% of the length of the substrate which is divided into two-segment solar cell. The length of one solar cell segment in three- segment solar cell is about 33% of the length of the substrate which is divided into three-piece solar cell. Referring to FIG 6, for two-segment solar cell, use welding strips 510 to string weld the solar cell segments 520, for three-segment solar cells, use welding strips 610 to string weld the solar cell segments 620. After the string welding process, the warpage height of the solar cell segment 520 is H2, and the warpage height of the solar cell segment 620 is H1. Here, the "warpage height" refers to the projected size of the solar cell segment in the fifth direction D5. Since the length of the solar cell segment 620 is shorter than the solar cell segment 520, the degree of warpage of the solar cell segment 620 after the string welding process is much smaller than that of the solar cell segment 520. The warping of the solar cells will increase the difficulty in controlling the string length of solar cell strings, cause fragmentation and cracks in the solar cell strings during the circulation process, and cause the risk of fragmentation and cracks during the lamination process. This disclosure reduces the difficulty of controlling the string length of solar cell strings by designing the substrate into three substrate segments, thereby improving the component appearance yield and electroluminescence (EL) yield, and it avoids the fragmentation and the cracks of the solar cell string during the circulation process, as well as reducing the risk of fragmentation and cracking during lamination.

In addition, the inventor of the present disclosure realizes that increasing the number of solar cell segments obtained by dividing the substrate would, on the one hand, reduce the warpage of the solar cell segments after the string welding process, but on the other hand, increase the number of connection jumpers and incorporate the design of special-shaped openings in the backside glass, which increases in process complexity and the risk of module breakage and decreases module production efficiency as well as. The inventor of the present disclosure find that the length of a solar cell segment in four-segment solar cell (that is, dividing the substrate into four solar cell segments) is only reduced by 8% compared to the length of a solar cell segment in a three-segment solar cell, which has little help for improving warpage, and the four-segment solar cell requires more connection jumpers to achieve a more complex series and parallel design, as well as the special-shaped openings design, in the backside glass, which will lead to a significant increase in process complexity, reduce the production yield of the module, and increase risk of component breakage during operation. Therefore, the three-segment solar cell of the present disclosure can simultaneously take into account warpage, process complexity, module production efficiency and module breakage risk, and has optimal economic benefits.

The inventor of the present disclosure also realizes that for the welding strips on the solar cell segment, the current on the welding strip increases as the length of the welding strip increases, and the increased current will cause power loss. The power loss can be reduced and the output power of the module can be increased by increasing the number of solar cell segments obtained by dividing the substrate. But as the number of the solar cell segments increases, the effect of increasing power gradually decreases. Furthermore, segmentation loss will occur when the substrate is segmented, and segmentation loss will lead to power loss. The power loss increases as the number of times the substrate is segmented increases. For example, the three-segment solar cell has twice the partitioning loss of the two-segment solar cell, the four-segment solar cell has three times the partition loss of the two-segment solar cell, and so on.

The inventor of the present disclosure combines the above two factors to calculate the relationship between power loss and the number of solar cell segments. Referring to the calculation results of the power loss when the same size substrate is divided into different segments shown in FIG 7, it can be seen that compared with using one entire substrate as one entire solar cell, the power loss of the two-piece solar cell is significantly reduced, compared with the two-segment solar cell, the power loss of the three-piece solar cell is also greatly reduced, but compared with the three-segment solar cell, although the power loss of the four-segment solar cell has been reduced, the reduction is very small, and it is basically the same as the power loss of the three-segment solar cell. However, compared with three-segment solar cell, the complexity of the segmentation process of four-segment solar cell will be significantly higher, which will lead to a reduction in production efficiency. Considering the contribution of four-segment solar cell to reducing power loss and the reduction in production efficiency, the contribution of four-piece solar cell to the final product is lower than that of three-segment solar cell. Therefore, the three-segment solar cell in this disclosure can ensure production efficiency, and reduce power loss.

The present disclosure also proposes another string welding method of solar cell, which is suitable for string welding a plurality of solar cells as shown in FIG 4. Next, the string welding method will be described through embodiments.

The string welding method includes the following steps,
Step S210: Obtaining at least two solar cells as shown in FIG 4,
Step S220: dividing the substrate of each solar cell into a first solar cell segment, a second solar cell segment, and a third solar cell segment along the dividing line between adjacent substrate segments of each solar cell segment,
Step S230: arranging the at least two solar cells adjacently in a fourth direction,, wherein the second solar cell segment in each solar cell is rotated 180°, and one solar cell in the adjacent solar cells is rotated 180° so that one first solar cell segment in adjacent solar cells is adjacent to another first solar cell segment in adjacent solar cells, or one third solar cell segment in adjacent solar cells is adjacent to another third solar cell segment in adjacent solar cells,
Step S240: string welding each solar cell in the at least two solar cells.

The differences between this string welding method and the previous string welding method (i.e., step S110 to step S140) are, (1) The solar cell segment in this string welding method comes from the substrate as shown in FIG 4, that is, the extension line of each positive main grid of one of solar cell segments in the entire solar cell coincides with the extension line of two positive main grids which locate on the other two solar cell segments respectively, and the extension line of each negative main grid of one of the solar cell segments coincides with the extension line of two negative main grids which locate on the other two solar cell segments respectively; (2) rotating the second solar cell segment in the entire solar cell 180° while string welding the solar cell segments.

For other details about the string welding method of the present disclosure, please refer to the relevant descriptions above which will not be repeated. The string welding method of this disclosure uses the three-piece solar cell mentioned above. When string welding the solar cell segments, the second solar cell segment in each entire solar cell is rotated 180°, and then one of the two adjacent entire solar cells is rotated, no alignment process is required, which has the advantage of fewer process steps and improves the production efficiency of photovoltaic modules.

The basic concepts have been described above. Obviously, for those skilled in the art, the above disclosure disclosures are only embodiments and do not constitute limitations to the present disclosure. Although not explicitly stated herein, those skilled in the art may make various modifications, improvements, and corrections to this disclosure. Such modifications, improvements, and corrections are suggested in this disclosure, so such modifications, improvements, and corrections still fall within the spirit and scope of the exemplary embodiments of this disclosure.

And, this disclosure uses specific words to describe the embodiments of the disclosure. For example, "one embodiment", "an embodiment", and/or "some embodiments" means a certain feature, structure, or characteristic related to at least one embodiment of the present disclosure. Therefore, it should be emphasized and noted that "one embodiment" or "an embodiment" or "an alternative embodiment" mentioned twice or more at different places in this specification does not necessarily refer to the same embodiment. In addition, certain features, structures or characteristics in one or more embodiments of the present disclosure may be appropriately combined.

In some embodiments, numbers are used to describe the quantities of components and properties. It should be understood that such numbers used to describe the embodiments are modified by the modifiers "about", "approximately" or "substantially" in some embodiments. Grooming. Unless otherwise stated, "about," "approximately," or "substantially" means that the stated number is allowed to vary by ± 20%. Accordingly, in some embodiments, the numerical parameters used in the specification and claims are approximations that may vary depending on the desired features of the individual embodiment. In some embodiments, numerical parameters should account for the specified number of significant digits and use general digit preservation methods. Although the numerical fields and parameters used to confirm the breadth of the ranges in some embodiments of the present disclosure are approximations, in specific embodiments, such numerical values are set as accurately as feasible.

## Claims

1. A back-contact solar cell, **characterized by** comprising:
a substrate (110) including three substrate segments (111, 112, 113), wherein the three substrate segments (111, 112, 113) are adjacently arranged in a first direction (D1); and
an even number of positive main grids (120) and negative main grids (130) located on a backlight surface of each substrate segment, wherein the positive main grids (120) and negative main grids (130) extend in the first direction and are alternately arranged in a second direction (D2), an extension line of each positive main grid (120) located on each substrate segment coincides with an extension line of one of the negative main grids (130) located on an adjacent substrate segment, and an extension line of each negative main grid (130) located on each substrate segment coincides with an extension line of one of the positive main grids (120) located on the adjacent substrate segment.

2. The solar cell according to claim 1, further comprises a plurality of rows of positive connection points and a plurality of rows of negative connection points, wherein the positive connection points of each row are arranged at intervals in the first direction on a corresponding positive main grid, and the negative connection points of each row are arranged at intervals in the first direction on a corresponding negative main grid.

3. The solar cell according to claim 1, wherein a total number of the positive main grids and the negative main grids is 4, 6, 8, 10, 12, 14, 16, 18, 20, 22, or 24, and a number of the negative main grids is same as a number of the positive main grids.

4. A back-contact solar cell segment, **characterized by** comprising: three solar cell segments obtained by dividing the solar cell according to any one of claims 1 to 3 along a dividing line between adjacent substrate segments, wherein the three solar cell segments correspond to the three substrate segments.

5. A photovoltaic module, **characterized by** comprising:
a plurality of solar cell segments according to claim 4, wherein the plurality of solar cell segments are arranged at intervals in a third direction, and an extension line of each positive main grid located on each solar cell segment coincides with an extension line of one of the negative main grids located on adjacent solar cell segments, and an extension line of each negative main grid located on each solar cell segment coincides with an extension line of one of the positive main grids located on adjacent solar cell segments; and
a plurality of welding strips extending in the third direction, wherein each welding strip connects one of the positive main grids with a corresponding negative main grid.

6. A string welding method of solar cell, **characterized by** comprising:
obtaining at least two solar cells according to any one of claims 1 to 3;
dividing each solar cell into a first solar cell segment, a second solar cell segment, and a third solar cell segment along a dividing line between adjacent substrate segments of each solar cell, wherein the first solar cell segment, the second solar cell segment, and the third solar cell segment respectively correspond to a first substrate segment, a second substrate segment, and a third substrate segment;
arranging the at least two solar cells adjacently in a third direction, wherein one of the adjacent solar cells is rotated 180° so that one first solar cell segment in the adjacent solar cells is adjacent to another first solar cell segment in the adjacent solar cells, or one third solar cell segment in the adjacent solar cells is adjacent to another third solar cell segment in the adjacent solar cells; and
string welding each solar cell segment of the at least two solar cells.

7. A back-contact solar cell, **characterized by** comprising:
a substrate (230) including three substrate segments (231, 232, 233), wherein three substrate segments (231, 232, 233) are adjacently arranged in a first direction (D1); and
an even number of positive main grids (240) and negative main grids (250) located on the backlight surface of each substrate segment, wherein the positive main grids (240) and the negative main grids (250) extend in the first direction and are alternately arranged in a second direction (D2), an extension line of each positive main grid (240) located on each substrate segments coincides with an extension line of one of the positive main grids (240) located on an adjacent substrate segment, an extension line of each negative main grid (250) on the substrate segment coincides with an extension line of one of the negative main grids (250) located on the adjacent substrate segment.

8. The solar cell according to claim 7, further comprises a plurality of rows of positive connection points and a plurality of rows of negative connection points, wherein the positive connection points of each row are arranged at intervals in the first direction on corresponding positive main grid, the negative connection points of each row are arranged at intervals in the first direction on a corresponding negative main grid.

9. The solar cell according to claim 7, wherein a total number of the positive main grids and the negative main grids is 4, 6, 8, 10, 12, 14, 1 6, 18, 20, 22, or 24, and a number of negative main grids is same as a number of positive main grids.

10. A back-contact solar cell segment, **characterized by** comprising: three solar cell segments obtained by dividing the solar cell according to any one of claims 7 to 9 along a dividing line between adjacent substrate segments, wherein the three solar cell segments correspond to the three substrate segments.

11. A photovoltaic module, **characterized by** comprising:
a plurality of solar cell segments according to claim 10, wherein the plurality of solar cell segments is arranged at intervals in a fourth direction, and an extension line of each positive main grid located on each solar cell segment coincides with an extension line of one of the negative main grids located on adjacent solar cell segments, and an extension line of each negative main grid located on each solar cell segment coincides with an extension line of one of the positive main grids located on adjacent solar cell segments; and
a plurality of welding strips extending in the fourth direction, wherein each welding strip connects the positive main grid with corresponding negative main grid.

12. A string welding method of solar cell, **characterized by** comprising:
obtaining an at least two solar cells according to any one of claims 7 to 9;
dividing each solar cell into a first solar cell segment, a second solar cell segment, and a third solar cell segment along a dividing line between adjacent substrate segments of each solar cell, wherein the first solar cell segment, the second solar cell segment, and the third solar cell segment respectively correspond to a first substrate segment, a second substrate segment, and a third substrate segment;
arranging the at least two solar cells adjacently in a fourth direction, wherein the second solar cell segment in each solar cell is rotated 180°, and one solar cell in the adjacent solar cells is rotated 180° so that one first solar cell segment in the adjacent solar cells is adjacent to another first solar cell segment in the adjacent solar cells, or one third solar cell segment in the adjacent solar cells is adjacent to another third solar cell segment in the adjacent solar cells; and
string welding each solar cell segment of the at least two solar cells.
